# EUROPEAN PATENT SPECIFICATION

(11) **EP 3 142 277 B1**
(45) Date of publication and mention of the grant of the patent: **12.12.2018**
(21) Application number: 14891259.5
(22) Date of filing: 09.10.2014
(51) Int. Cl.: H04L 1/00

(54) **FAULT TOLERANCE METHOD AND APPARATUS FOR MICROWAVE TRANSMISSION AND COMPUTER READABLE STORAGE MEDIUM**
FEHLERTOLERANZVERFAHREN UND VORRICHTUNG ZUR MIKROWELLENÜBERTRAGUNG UND COMPUTERLESBARES SPEICHERMEDIUM
PROCÉDÉ ET APPAREIL DE TOLÉRANCE AUX PANNES POUR TRANSMISSION HYPERFRÉQUENCE, ET SUPPORT D'INFORMATIONS LISIBLE PAR ORDINATEUR

(30) Priority: 09.05.2014 CN 201410195738
(43) Date of publication of application: 15.03.2017
(73) Proprietor: Sanechips Technology Co., Ltd., Nanshan District Shenzhen, Guangdong 518055 (CN)
(72) Inventor: FENG, Gang, Shenzhen Guangdong 518055 (CN)
(74) Representative: Lavoix
(86) International application number: PCT/CN2014/088228
(87) International publication number: WO 2015/169049

(56) References cited:
- WO-A1-2009/126704
- CN-A- 101 136 727
- CN-A- 101 378 289
- CN-A- 101 512 952
- US-A1- 2006 195 753
- US-A1- 2007 297 451
- US-A1- 2010 322 093

## Description

### TECHNICAL FIELD

The disclosure relates to the field of microwave transmission, and in particular to a fault tolerance method and apparatus for microwave transmission and a computer-readable storage medium.

### BACKGROUND

The majority of existing microwave transmission systems are error-bit-free peer-to-peer wireless communication systems. Conventional microwave systems forward data only when there are no error bits in output from a Low Density Parity Check (LDPC). By adopting such transmission method, the establishment of a link takes more time, although the bit error rate of the system is kept relatively low.

Moreover, in conventional microwave systems, the payload data included in the timeslot data in a radio frame is divided into Time Division Multiplexing (TDM) data unit and Media Access Control Protocol Data Unit (MAC PDU) which represents Ethernet (ETH) data. Moreover, the timeslot data also includes bitmap data for indicating the fragment structure of the TDM data. However, when the bitmap data is incorrect, the TDM data is affected, and besides, the packet header of an MAC PDU cannot be recognized accurately, and subsequently the fault is transferred in radio frames, making it impossible to transmit data normally.

WO 2009126704 A1 discloses a method for improved decoding of hybrid automatic repeat request (H-ARQ) transmissions, including: attempting to verify a physical layer (PHY) cyclic redundancy check for a candidate H-ARQ encoder packet. If the PHY CRC is not verified, medium access control layer protocol data units (MPDUs) may be identified in the candidate H-ARQ encoder packet, and attempts may be made to verify a medium access control layer(MAC) CRC for each MPDU in the candidate H-ARQ encoder packet.

### SUMMARY

To address existing technical problems, the embodiments of the disclosure mainly provides a fault tolerance method and apparatus for microwave transmission and a computer-readable storage medium.

The technical solutions of the disclosure are as follows.

A fault tolerance method for microwave transmission is provided which includes the following steps:
a receiving baseband device arranges a bitmap Cyclic Redundancy Check (CRC) code following a bitmap data in a timeslot data of a radio frame; and
the check result of the bitmap CRC code is detected and the service data following the bitmap CRC code is processed according to the check result;
the length of the bitmap data is 1 byte, and the value of the bitmap represents a fragment structure of a Time Division Multiplexing, TDM, data in the timeslot data; the TDM data is divided into four types of data, and the bitmap data indicates a specific channel of the TDM data that are successively transmitted in current timeslot data; and the arranged bitmap CRC code is used for checking the bitmap data;
detecting (302) the check result of the bitmap CRC code and processing the service data following the bitmap CRC code according to the check result comprises: detecting the bitmap data and the bitmap CRC code, performing a CRC check on the bitmap data to obtain the CRC result of the bitmap CRC, and when the check result of the bitmap CRC code is 'incorrect', which indicates that the bitmap data is incorrect, processing the service data following the bitmap CRC code by taking all the service data as Ethernet, ETH, data, and when the check result of the bitmap CRC code is 'correct', which indicates that that the bitmap data is correct, forwarding the service data following the bitmap CRC code normally.

In the foregoing solution, the length of the arranged bitmap CRC code is 1 byte.

In the foregoing solution, processing the service data following the bitmap CRC code by taking all the service data as ETH data includes: when the check result of the bitmap CRC code is 'incorrect', the receiving baseband device takes the first 16-bit data following the bitmap CRC code as MAC header in MAC PDU and analyzes an MAC header to obtain the fragment information of the payload data in the MAC PDU; packets are assembled according to the fragment information of the payload data in each MAC PDU, the assembled packets are stored and reassembled, and the reassembled packets are output and checked.

In the foregoing solution, the MAC PDU includes an MAC header and payload data.

The length of the MAC header is 16 bits, including the first two bits for representing the fragment information of the payload data that indicates the fragment of an ETH packet the payload data belongs to, the fragment being a packet header, a packet body, a packet tail or a complete packet; eleven middle bits for representing the length of the payload data; and last three bits for representing another type of service to be transmitted through an ETH channel.

The maximum length of the payload data is 2048 bits.

In the foregoing solution, assembling packets according to the fragment information of the payload data in each MAC PDU includes: obtaining each fragment in an ETH packet according to the fragment information, forming the fragments into a complete ETH packet, and obtaining the packet length and the packet data of the ETH packet.

In the foregoing solution, storing and reassembling the assembled packets includes: storing the packet length and the packet data of the ETH packet in two First-In First-Out (FIFO) storage units, respectively; and reassembling, at outputs of the FIFO storage units, the data in the FIFO storage units according to the packet length and the packet data to obtain the complete ETH packet.

In the foregoing solution, outputting and checking the reassembled packets includes: outputting the reassembled ETH packets and performing the CRC on the ETH packet and, when the check result is 'incorrect', cleaning a result of analysis on the assembled packets, the data stored in the FIFO storage units and the data output, and detecting an MAC header of a packet header in an ETH packet in the next timeslot data to assemble packets.

A fault tolerance apparatus for microwave transmission is also provided which includes a check code arranging module and a processing module.

The check code arranging module is arranged to arrange a bitmap CRC code following a bitmap data in a timeslot data of a radio frame;

The processing module is arranged to detect a check result of the bitmap CRC code and process service data following the bitmap CRC code according to the check result; the length of the bitmap data is 1 byte, and the value of the bitmap represents a fragment structure of a Time Division Multiplexing, TDM, data in the timeslot data; the TDM data is divided into four types of data, and the bitmap data indicates a specific channel of the TDM data that are successively transmitted in current timeslot data; and the arranged bitmap CRC code is used for checking the bitmap data;
the processing module (81) comprises a CRC detection sub-module (90) and a data processing sub-module (91),
the CRC detection sub-module (90) is arranged to detect the bitmap data and the bitmap CRC code and perform a CRC check on the bitmap data to obtain the CRC result of the bitmap CRC; and
the data processing sub-module (91) is arranged to process the service data following the bitmap CRC code by taking all the service data as Ethernet, ETH, data when the check result of the bitmap CRC code is 'incorrect', and to forward the service data following the bitmap CRC code normally when the check result of the bitmap CRC code is 'correct'.

In the foregoing solution, the length of the bitmap CRC code is 1 byte .

In the foregoing solution, the data processing sub-module is arranged to take the first 16-bit data following the bitmap CRC code as an MAC header in an MAC PDU and analyze the MAC header to obtain the fragment information of the payload data in the MAC PDU when the check result of the bitmap CRC code is 'incorrect', assemble packets according to the fragment information of the payload data in each MAC PDU, store and reassemble the assembled packets and output and check the reassembled packets.

In the foregoing solution, the MAC PDU includes an MAC header and payload data.

The length of the MAC header is 16 bits, including: the first two bits for representing the fragment information of the payload data that indicates the fragment of an ETH packet the payload data belongs to, the fragment being a packet header, a packet body, a packet tail or a complete packet; eleven middle bits for representing the length of the payload data; and last three bits for representing another type of service to be transmitted through an ETH channel.

The maximum length of the payload data is 2048 bits.

In the foregoing solution, the data processing sub-module is arranged to obtain each fragment in an ETH packet according to the fragment information when assembling packets according to the fragment information of the payload data in each MAC PDU, form the fragments into a complete ETH packet and obtain the packet length and the packet data of the ETH packet.

In the foregoing solution, the data processing sub-module is arranged to store, when storing and reassembling the assembled packets, the packet length and the packet data of the ETH packet in two First-In First-Out (FIFO) storage units, respectively, and reassemble, at the output end of the FIFO storage units, the data in the FIFO storage units according to the packet length and the packet data to obtain the complete ETH packet.

In the foregoing solution, the data processing sub-module is arranged to output the reassembled ETH packets and perform the CRC on the reassembled packet when outputting and checking the packet and, when the check result is 'incorrect', clean a result of analysis on the assembled packets, the data stored in the FIFO storage units and the data output, and detect the MAC header of the packet header in the ETH packet in the next timeslot data to assemble packets.

The disclosure further provides a computer-readable storage medium which contains a set of computer-executable instructions for executing the foregoing fault tolerance method for microwave transmission.

According to the fault tolerance method and apparatus for microwave transmission and the computer-readable storage medium provided herein, a receiving baseband device arranges a bitmap CRC code following a bitmap data in a timeslot data of a radio frame, detects the check result of the bitmap CRC code and processes the service data following the bitmap CRC code according to the check result. In this way, a link can be established as long as the key information of a radio frame in a microwave system is correct. Thus, the establishment time of a link can be significantly reduced. Furthermore, with the implementation of few redundancy checks, data loss can be minimized without causing the loss of correct TDM data or ETH data, and the ETH packet included in only one piece of incorrect timeslot data will be forwarded.

### BRIEF DESCRIPTION OF THE DRAWINGS

Fig. 1 is a schematic diagram illustrating a structure of a radio frame according to an embodiment of the disclosure;
Fig. 2 is a schematic diagram illustrating a structure of a piece of timeslot data included in existing radio frame;
Fig. 3 is a flow chart illustrating a process of a fault tolerance method for microwave transmission according to an embodiment of the disclosure;
Fig. 4 is a schematic diagram illustrating a structure of a piece of timeslot data with a bitmap CRC code according to an embodiment of the disclosure;
Fig. 5 is a schematic diagram illustrating a structure of an MAC header according to an embodiment of the disclosure;
Fig. 6 is a schematic diagram showing a state machine for realizing a solution provided herein, according to an embodiment of the disclosure;
Fig. 7 is a flow chart illustrating a procedure of processing ETH data according to an embodiment of the disclosure; and
Fig. 8 is a schematic diagram illustrating a structure of a fault tolerance apparatus for microwave transmission according to an embodiment of the disclosure.

### DETAILED DESCRIPTION

In embodiments of the disclosure, a receiving baseband device arranges a bitmap CRC code following a bitmap data in a timeslot data of a radio frame, detects the check result of the bitmap CRC code and processes the service data following the bitmap CRC code according to the check result.

The disclosure is described below in detail with reference to specific embodiments when read in conjunction with accompanying drawings.

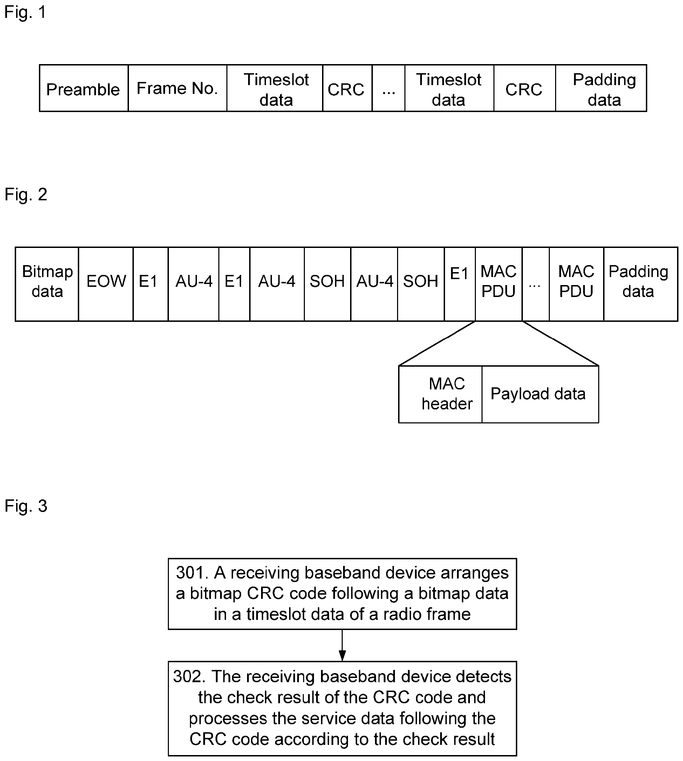

In the structure of the radio frame as shown in Fig. 1, the preamble and the frame No. at the head of a frame are is inserted by a receiving link. The key point of the method and apparatus provided herein lies in the timeslot data following the preamble and the frame No. A plurality of pieces of timeslot data are included in a radio frame. The timeslot data is followed by a CRC code. When the length of all data is less than length of a frame, padding data at the end of the frame is used to compensate the length of the frame.

Fig. 2 is a diagram showing a structure of existing timeslot data. As shown in Fig. 2, timeslot data is divided into TDM data and ETH data which is represented by MAC PDU. TDM data is divided into four types of data, i.e., EOW, E1, AU-4 and SOH. In a session service, EOW occupies a fixed bandwidth and is adapted to transmit TDM data using one of E1, AU-4 and SOU. The numbers of channels of E1, AU-4 or SOH that can be supported by the TDM data at most depend upon the configured transmission bandwidth. For example, when transmission bandwidth is 28M, a system can support 75 channels of E1, 2 channels of AU-4s or 2 channels of SOH at most. The bitmap data indicates the specific channels of the TDM data that are successively transmitted in the current timeslot data. For example, if packets are transmitted in three channels of E1, that is, the first channel of E1, the third channel of E1 and the eighth channel of E1, in the current timeslot data, then the bitmap data is 10100001. The numeral '1' represents fragments of E1, that is, the first E1 fragment is in the first channel of the data following, the second E1 fragment is in the third channel of the data following and the third E1 fragment is in the eighth channel of the data following. If there is remaining space in the timeslot data for transmitting data, in addition to TDM data, then the remaining space is used to transmit ETH data (represented by MAC PDU). MAC PDU is divided into an MAC header and payload data. There may be a plurality of MAC PDUs in a piece of timeslot data, and padding data is used to compensate the fixed length of a piece of timeslot data when the length of all data fails to reach the fixed length of the piece of timeslot data.

In a case where data is transmitted using the timeslot data structure as shown in Fig. 2, when bitmap data is incorrect, not only the TDM data but also the ETH data following is affected. For example, if correct bitmap data '10100001', which means that the first, the third and the eighth channel of data is the TDM data, is changed to incorrect bitmap data '10100100', which means that the first, the third and the sixth channel of data is TDM data, when being transmitted, the correctness of TDM data is reduced. Moreover, the ETH data following the TDM data cannot be recognized correctly. It is supposed to indicate that MAC PDU representing ETH is straight after the eighth channel of TDM data. However, it is now deemed by a receiving device that the MAC PUD is straight after the sixth channel of TDM data, and this error is transferred continuously, making it impossible to recover the correct transmission of data.

Fig. 3 is a flow chart illustrating a process of a fault tolerance method for microwave transmission according to an embodiment of the disclosure. As shown in Fig. 3, the fault tolerance method mainly includes the following steps.

In step 301, a receiving baseband device arranges a bitmap CRC code following a bitmap data in a timeslot data of a radio frame.

The length of the bitmap data is 1 byte, and a value of the bitmap represents the fragment structure of the TDM data in the timeslot data.

The length of the arranged bitmap CRC code is 1 byte long, is arranged to follow the bitmap data for checking the bitmap data.

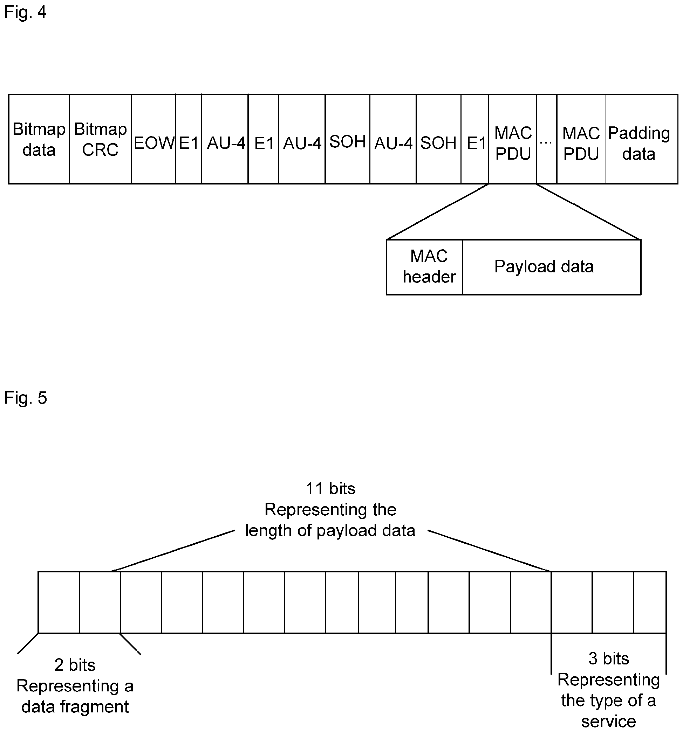

Fig. 4 is a schematic diagram illustrating a structure of a piece of timeslot data followed by the bitmap CRC code. Compared with the timeslot data as shown in Fig. 2, the timeslot datum as shown in Fig. 4 additionally includes a 1-byte CRC code for checking the correctness of bitmap data.

In step 302, the receiving baseband device detects the check result of the bitmap CRC code and processes the service data following the bitmap CRC code according to the check result.

Specifically, the bitmap data and the bitmap CRC code included in the timeslot data received are detected. An operation is performed on data composed of the bitmap data and the bitmap CRC code based on a principle of CRC to obtain the check result of the bitmap CRC code. When the check result of the bitmap CRC code is 'incorrect', which indicates that the bitmap data is incorrect, the service data following the bitmap CRC code is processed by taking all the service data as ETH data, no matter whether the service data following the bitmap CRC code is TDM data or MAC PDU. When the check result of the bitmap CRC code is 'correct', the service data following the bitmap CRC code is forwarded normally, that is, the service data following the bitmap CRC code is forwarded by using a data processing method that is corresponding to the type of the data following the bitmap CRC code.

A principle of CRC is specifically as follows: a generator polynomial is selected when a bitmap CRC code is arranged, the bitmap data is shifted left by 8 bits (shifted left by the number of the bits of a CRC code), the reminder resulting from the division of the left-shifted bitmap data by the generator polynomial using the module 2 division is a CRC code; if the reminder resulting from the division of the 16-bit data composed of the received bitmap data and the bitmap CRC code by the generator polynomial using the module 2 division is 0, then the result of the check is 'correct', otherwise, the result of the check is 'incorrect'.

Processing the service data following the bitmap CRC code by taking all the service data as ETH data is implemented as follows. When the check result of the bitmap CRC code is 'incorrect', the first 16-bit data following the bitmap CRC code is taken as an MAC header in an MAC PDU and the MAC header is analyzed to obtain fragment information of a payload data in the MAC PDU. And packets are assembled according to the fragment information of the payload data in each MAC PDU. Then, the assembled packets are stored and reassembled, and the reassembled packets are outputted and checked.

As shown in Figs. 2 and 4, the MAC PDU includes: an MAC header and payload data.

As shown in Fig. 5, the length of the MAC header is 16 bits, including: the first two bits for representing the fragment information of the payload data; eleven middle bits for representing the length of the payload data; and last three bits for representing another type of service to be transmitted through an ETH channel. The fragment information of the payload data indicates the fragment of an ETH packet the payload data belongs to, the fragment of an ETH packet may be a packet header, a packet body, a packet tail or a complete packet. For example, 00 represents that the payload data belongs to the packet header of an ETH packet, 01 represents that the payload data belongs to the packet body of an ETH packet, 10 represents that the payload data belongs to the packet tail of an ETH packet, and 11 represents the payload data belongs to a complete packet. For example, if the eleven middle bits of the MAC header is 00000001111, then the length of the payload data following the MAC header is 15 bits, that is, the 15-bit data following the MAC header is the payload data of the current MAC PDU.

Assembling packets according to the fragment information of the payload data in each MAC PDU is implemented as follows. Each fragment in an ETH packet is obtained according to the fragment information. And the fragments are formed into a complete ETH packet. Then, the packet length and the packet data of the ETH packet are obtained.

For example, the payload data in three different MAC PDUs separately constitutes the packet header, the packet body and the packet tail of an ETH packet, and a complete ETH packet can be formed by assembling the payload data in the three MAC PDUs. Alternatively, the packet header, the packet body and the packet tail of an ETH packet may be distributed in different MAC PDUs. Alternatively, an ETH packet may be born in a plurality of pieces of timeslot data, depending on specific circumstances.

Storing and reassembling the assembled packets is implemented as follows. The packet length and the packet data of the ETH packet are stored in two First-In First-Out (FIFO) storage units, respectively. And at the output end of the FIFO storage units, the data in the FIFO storage units is reassembled according to the packet length and the packet data to obtain the complete ETH packet.

Outputting and checking the reassembled packets is implemented as follows. The reassembled ETH packets are outputted, the CRC is performed on the reassembled ETH packet. When the check result is 'incorrect', a result of analysis on the assembled packets, the data stored in the FIFO storage units and the data output are cleaned, and the MAC header of the packet header of the ETH packet in the next timeslot data is detected to assemble packets. When the check result is 'correct', a result of analysis on the assembled packets, the data stored in the FIFO storage unit and the output data are remained.

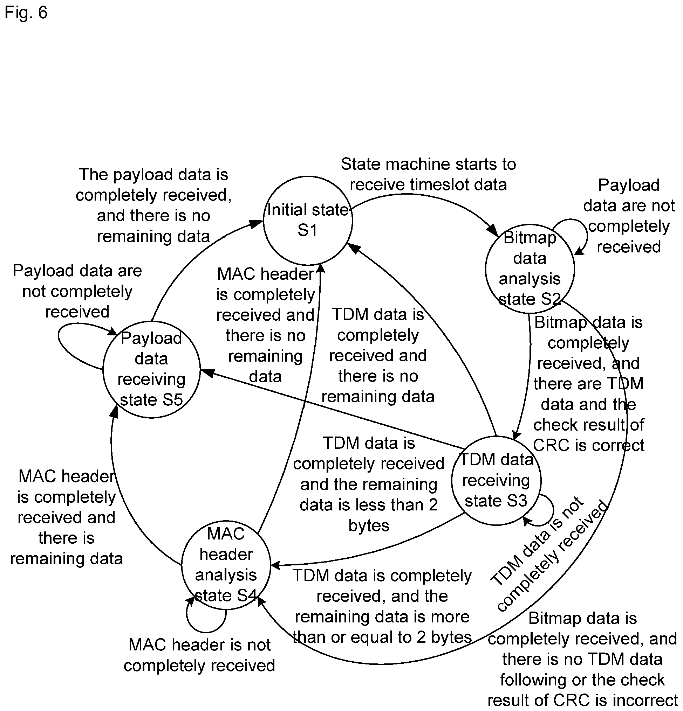

Fig. 6 is a schematic diagram showing a state machine for realizing the solutions provided in the embodiments of the disclosure. The state machine has five states, an initial state S1, a bitmap data analysis state S2, a TDM data receiving state S3, an MAC header analysis state S4 and a payload data receiving state S5.

The principle of the transfer of the state machine is as follows. The state machine initially stays in the initial state S1. When timeslot data arrives, the state machine switches to the bitmap data analysis state S2. In the state S2, the bitmap data in the timeslot data is received, until the bitmap data is completed received. The bitmap data is analyzed. When the result of the analysis indicates that there is no TDM data in the subsequent data or when the result of CRC is "incorrect", the state machine switched to the MAC header analysis state S4. In the MAC header analysis state S4, the MAC header is analyzed. When MAC header data is all received and analyzed in the state S4 and no remaining data follows the received MAC header data, the state machine return to the initial state S1. When MAC header is all received and there is remaining data following the received MAC header, the state machine enters the payload data receiving state S5. In the payload data receiving state S5, the payload data is received until there is no remaining data following the payload data, then the state machine return to the initial state S1.

If it is known from the analysis of the bitmap data received in the state S2 that there are following TDM data and the check result of bitmap CRC is 'correct', the state machine switches to the TDM data receiving state S3. TDM data is received in the state S3. After the TDM data is received and no remaining data follows the TDM data received, the state machine switches back to the initial state S1. When the TDM data is received and the length of the remaining data following the TDM data received is less than 2 bytes (shorter than one 2-byte MAC header), the state machine switched to the payload data receiving state S5. When the TDM data is received and the length of the remaining data following the TDM data received is greater than or equal to 2 bytes, the state machine switches to the MAC header analysis state S4. The MAC header data is analyzed in the state S4. When the MAC header data is all received and no remaining data follows the MAC header data, the state machine switches back to the initial state S1. When the MAC header data is all received and there is remaining data following the MAC header data, the state machine switches to the payload data receiving state S5.

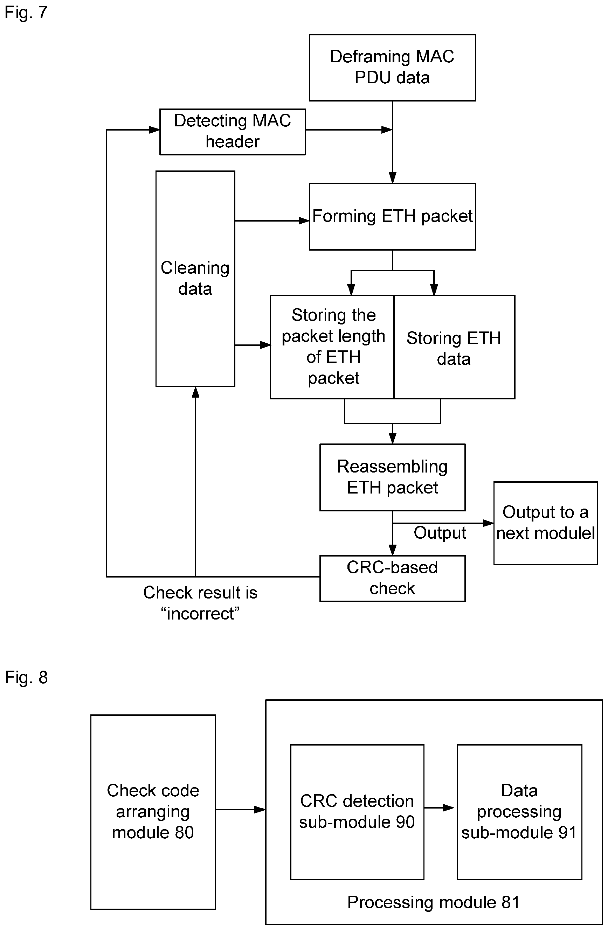

Fig. 7 is a flow chart illustrating a procedure of processing ETH data. Specifically, the processing flow is as follows. MAC PDU data is deframed at a former level. A packing analysis is performed on the deframed PDU data to obtain an ETH packet. The packet length of the ETH packet is determined according to the packet header and the packet tail of the ETH packet. The packet length and ETH data are stored in different FIFO storage units, respectively. As shown in Fig. 7, a first FIFO storage unit is arranged to store ETH data, and a second FIFO storage unit is arranged to store the packet length of an ETH packet. The ETH packet is reassembled and checked at the output end of the FIFO storage units. That is, data is acquired from the first FIFO storage unit according to the packet length stored in the second FIFO storage unit to form a complete ETH packet. The ETH packet is output to a module of the next level which is located in a device on a data link layer and which is a different device in a level different from that of the foregoing receiving baseband device on a transmission layer. Meanwhile, the ETH packet is checked using the CRC code carried in the ETH packet. When the check result is 'incorrect', the ETH packet resulting from a data packing analysis and the data stored in the FIFO storage units are cleaned, the output data is cleaned immediately. The MAC header of the packet header of the ETH packet included in the next timeslot data is detected to assemble packets. Cleaning of the output data is implemented by changing all the output from the output port of the receiving baseband device to 0.

Fig. 8 is a diagram showing a structure of a fault tolerance apparatus for microwave transmission according to an embodiment of the disclosure. The fault tolerance apparatus includes a check code arranging module 80 and a processing module 81.

The check code arranging module 80 is arranged to arrange a bitmap CRC code following a bitmap data in a timeslot data of a radio frame.

The processing module 81 is arranged to detect a check result of the bitmap CRC code and process service data following the bitmap CRC code according to the check result.

The length of the bitmap data is 1 byte long, and the bitmap data represents the fragment structure of the TDM data included in the timeslot data.

The length of the bitmap CRC code is 1 byte long, and the bitmap data is used for checking the bitmap data.

The processing module 81 includes a CRC detection sub-module 90 and a data processing sub-module 91.

The CRC detection sub-module 90 is arranged to detect the bitmap data and the bitmap CRC code and perform an operation on data composed of the bitmap data and the bitmap CRC code based on a principle of CRC to obtain the check result of the bitmap CRC code.

The data processing sub-module 91 is arranged to process the service data following the bitmap CRC code by taking all the service data as ETH data when the check result of the bitmap CRC code is 'incorrect', and to forward the service data following the bitmap CRC code normally when the check result of the bitmap CRC code is 'correct'.

The data processing sub-module 91 is arranged to take the first 16-bit data following the bitmap CRC code as a Media Access Control Protocol (MAC) header in a Media Access Control Protocol Data Unit (MAC PDU) and analyze the MAC header to obtain fragment information of payload data in the MAC PDU, when the check result of the bitmap CRC code is 'incorrect'; assemble packets according to the fragment information of the payload data in each MAC PDU, store and reassemble the packets, and output and check the reassembled packets; and to forward the service data following the bitmap CRC code normally when the check result of the bitmap CRC code is 'correct'.

The MAC PDU includes: an MAC header and payload data.

The length of the MAC header is 16 bits, including: the first two bits for representing the fragment information of the payload data that indicates the fragment of an ETH packet the payload data belongs to, the fragment is a packet header, a packet body, a packet tail or a complete packet; eleven middle bits for representing the length of the payload data; and last three bits for representing another type of service to be transmitted through an ETH channel.

The maximum length of the payload data is 2048 bits.

The data processing sub-module 91 is arranged to obtain, when assembling packets according to the fragment information of the payload data in each MAC PDU, each fragment in an ETH packet according to the fragment information, form the fragments into a complete ETH packet and obtain the packet length and the packet data of the ETH packet.

The data processing sub-module stores the packet length and the packet data of the ETH packet in two FIFO storage units, respectively when storing and reassembling the assembled packets; and reassemble, at the output end of the FIFO storage units, the data stored in the FIFO storage units according to the packet length and the packet data to obtain the complete ETH packet.

The data processing sub-module 91 is arranged to output the reassembled ETH packets and perform the CRC on the ETH packet when outputting and checking the reassembled ETH packets and, when the check result is 'incorrect', clean the result of the analysis on the packets, the data stored in the FIFO storage units and the data output, and detect the MAC header of the packet header of the ETH packet in the next timeslot data to assemble packets.

The check code arranging module 80 may be implemented as a chip with a simple operation implementation capability, for example, a singlechip, that is located in a device, or a main processing chip.

The processing module 81 may be made up of the main processing chip of a receiving baseband device and the peripheral circuits thereof, for example, an FPGA and peripheral circuits thereof.

The disclosure further provides a computer-readable storage medium which contains a set of computer-executable instructions for executing the foregoing fault tolerance method for microwave transmission.

The fault tolerance method for microwave transmission provided herein, if implemented as a software function module and sold or used as an independent product, can be stored in a computer-readable storage medium. It should be appreciated by those skilled in the art that the embodiments of the disclosure can be provided as methods, systems or computer program products. Thus, the disclosure can be embodied as pure hardware embodiments, pure software embodiments or the combinations of hardware embodiments and software embodiments. Moreover, the disclosure may be embodied in the form of a computer program product implemented on one or more computer-usable storage medium, including, but not limited to, Universal Serial Bus (USB) drive, removable hard disk drive, Read-Only Memory (ROM), disk memory, CD-ROM and optical memory, on which computer-readable program codes are stored.

In the embodiments of the disclosure, a bitmap CRC code following a bitmap data in a timeslot data of a radio frame is arranged, the check result of the bitmap CRC code is detected, and the service data following the bitmap CRC code is processed according to the check result, such that the establishment time of a link during the process of microwave transmission is reduced. Moreover, due to the arranged bitmap CRC code, only one ETH packet is forwarded when certain bitmap data of radio frame data is incorrect. Thus, the error is not transferred continuously to disenable the recovery of the normal transmission of data.

Although preferred embodiments of the disclosure are illustrated above, the preferred embodiments are not to be construed as limiting the protection scope of the disclosure, and any modification, substitute or improvement devised without departing from the scope of the present invention should fall within the protection scope of the disclosure.

## Claims

1. A fault tolerance method for microwave transmission, comprising:
arranging (301), by a receiving baseband device, a bitmap Cyclic Redundancy Check, CRC, code following a bitmap data in a timeslot data of a radio frame; and
detecting (302) the check result of the bitmap CRC code and processing the service data following the bitmap CRC code according to the check result;
wherein the length of the bitmap data is 1 byte, and the value of the bitmap represents a fragment structure of a Time Division Multiplexing, TDM, data in the timeslot data; wherein the TDM data is divided into four types of data, and the bitmap data indicates a specific channel of the TDM data that are successively transmitted in current timeslot data; and the arranged bitmap CRC code is used for checking the bitmap data;
wherein detecting (302) the check result of the bitmap CRC code and processing the service data following the bitmap CRC code according to the check result comprises: detecting the bitmap data and the bitmap CRC code, performing a CRC check on the bitmap data to obtain the CRC result of the bitmap CRC, and when the check result of the bitmap CRC code is 'incorrect', which indicates that the bitmap data is incorrect, processing the service data following the bitmap CRC code by taking all the service data as Ethernet, ETH, data, and when the check result of the bitmap CRC code is 'correct', which indicates that that the bitmap data is correct, forwarding the service data following the bitmap CRC code normally.

2. The fault tolerance method according to claim 1, wherein the length of the arranged bitmap CRC code is 1 byte.

3. The fault tolerance method according to claim 2, wherein processing the service data following the bitmap CRC code by taking all the service data as ETH data comprises:
when the check result of the bitmap CRC code is 'incorrect', taking, by the receiving baseband device, the first 16-bit data following the bitmap CRC code as a Media Access Control, MAC, header in a Media Access Control Protocol Data Unit, MAC PDU, and analyzing the MAC header to obtain fragment information of a payload data in the MAC PDU; assembling packets according to the fragment information of the payload data in each MAC PDU, storing the assembled packets and reassembling the packets, and outputting and checking the reassembled packets.

4. The fault tolerance method according to claim 3, wherein the MAC PDU includes: an MAC header and payload data, wherein
the length of the MAC header is 16 bits, including: the first two bits for representing the fragment information of the payload data that indicates the fragment of an ETH packet the payload data belongs to, the fragment being a packet header, a packet body, a packet tail or a complete packet; eleven middle bits for representing the length of the payload data; and last three bits for representing another type of service to be transmitted through an ETH channel; and the maximum length of the payload data is 2048 bits.

5. The fault tolerance method according to claim 3 or 4, wherein assembling packets according to the fragment information of the payload data in each MAC PDU comprises: obtaining each fragment in an ETH packet according to the fragment information, forming the fragments into a complete ETH packet, and obtaining the packet length and the packet data of the ETH packet.

6. The fault tolerance method according to any one of claims 3-5, wherein storing and reassembling the assembled packets comprises: storing the packet length and the packet data of the ETH packet in two First-In First-Out, FIFO, storage units, respectively; and reassembling, at outputs of the FIFO storage units, the data in the FIFO storage units according to the packet length and the packet data to obtain the complete ETH packet.

7. The fault tolerance method according to any one of claims 3-6, wherein outputting and checking the reassembled packets comprises: outputting the reassembled ETH packets and performing the CRC on the reassembled ETH packets and when the check result is 'incorrect', cleaning a result of analysis on the assembled packets, the data stored in the FIFO storage units and the data output, and detecting an MAC header of a packet header in an ETH packet in the next timeslot data to assemble packets.

8. A fault tolerance apparatus for microwave transmission, comprising: a check code arranging module (80) and a processing module (81), wherein
the check code arranging module (80) is arranged to arrange a bitmap Cyclic Redundancy Check, CRC, code following a bitmap data in a timeslot data of a radio frame; and
the processing module (81) is arranged to detect the check result of the bitmap CRC code and process the service data following the bitmap CRC code according to the check result;
wherein the length of the bitmap data is 1 byte, and the value of the bitmap represents a fragment structure of a Time Division Multiplexing, TDM, data in the timeslot data; wherein the TDM data is divided into four types of data, and the bitmap data indicates a specific channel of the TDM data that are successively transmitted in current timeslot data; and the arranged bitmap CRC code is used for checking the bitmap data;
wherein the processing module (81) comprises a CRC detection sub-module (90) and a data processing sub-module (91), wherein
the CRC detection sub-module (90) is arranged to detect the bitmap data and the bitmap CRC code and perform a CRC check on the bitmap data to obtain the CRC result of the bitmap CRC; and
the data processing sub-module (91) is arranged to process the service data following the bitmap CRC code by taking all the service data as Ethernet, ETH, data when the check result of the bitmap CRC code is 'incorrect', and to forward the service data following the bitmap CRC code normally when the check result of the bitmap CRC code is 'correct'.

9. The fault tolerance apparatus according to claim 8, wherein the length of the arranged bitmap CRC code is 1 byte.

10. The fault tolerance apparatus according to claim 9, wherein the data processing sub-module (91) is arranged to take the first 16-bit data following the bitmap CRC code as a Media Access Control Protocol, MAC, header in a Media Access Control Protocol Data Unit, MAC PDU, and analyze the MAC header to obtain fragment information of payload data in the MAC PDU, when the check result of the bitmap CRC code is 'incorrect'; assemble packets according to the fragment information of the payload data in each MAC PDU, store and reassemble the packets, and output and check the reassembled packets.

11. The fault tolerance apparatus according to claim 10, wherein the MAC PDU includes: an MAC header and payload data, wherein
the length of the MAC header is 16 bits, including: the first two bits for representing the fragment information of the payload data that indicates the fragment of an ETH packet the payload data belongs to, the fragment being a packet header, a packet body, a packet tail or a complete packet; eleven middle bits for representing the length of the payload data; and last three bits for representing another type of service to be transmitted through an ETH channel; and the maximum length of the payload data is 2048 bits.

12. The fault tolerance apparatus according to claim 10 or 11, wherein the data processing sub-module (91) is arranged to obtain, when assembling packets according to the fragment information of the payload data in each MAC PDU, each fragment in an ETH packet according to the fragment information, form the fragments into a complete ETH packet and obtain the packet length and the packet data of the ETH packet.

13. The fault tolerance apparatus according to any one of claims 10-12, wherein the data processing sub-module (91) is arranged to store, when storing and reassembling the packets, the packet length and the packet data of the ETH packet in two First-In First-Out, FIFO, storage units, respectively, and reassemble, at outputs of the FIFO storage units, the data in the FIFO storage units according to the packet length and the packet data to obtain the complete ETH packet.

14. The fault tolerance apparatus according to any one of claims 10-13, wherein the data processing sub-module (91) is arranged to output the reassembled ETH packets and perform the CRC on the reassembled ETH packet when outputting and checking the reassembled packets; and, when the check result is 'incorrect', clean a result of analysis on the assembled packets, the data stored in the FIFO storage units and the data output, and detect an MAC header of a packet header in an ETH packet in the next timeslot data to assemble packets.

15. A computer-readable storage medium comprising instructions which, when executed by a computer, cause the computer to carry out the method of any one of claims 1-7.

## Patentansprüche

1. Fehlertoleranzverfahren zur Mikrowellenübertragung, umfassend:
Anordnen (301) eines Bitmap-CRC (zyklische Redundanzprüfung)-Codes nach Bitmap-Daten in Zeitschlitzdaten eines Funkrahmens durch eine empfangende Basisbandvorrichtung; und
Erkennen (302) des Prüfergebnisses des Bitmap-CRC-Codes und Verarbeiten der Dienstdaten nach dem Bitmap-CRC-Code gemäß dem Prüfergebnis;
wobei die Länge der Bitmap-Daten 1 Byte beträgt, und der Wert der Bitmap eine Fragmentstruktur von Zeitmultiplex, TDM,-Daten in den Zeitschlitzdaten darstellt; wobei die TDM-Daten in vier Typen von Daten unterteilt sind, und die Bitmap-Daten einen spezifischen Kanal der TDM-Daten angeben, die in aktuellen Zeitschlitzdaten nacheinander gesendet werden; und der angeordnete Bitmap-CRC-Code zum Prüfen der Bitmap-Daten verwendet wird;
wobei das Erkennen (302) des Prüfergebnisses des Bitmap-CRC-Codes und Verarbeiten der Dienstdaten nach dem Bitmap-CRC-Code gemäß dem Prüfergebnis umfasst: Erkennen der Bitmap-Daten und des Bitmap-CRC-Codes, Durchführen einer CC-Prüfung an den Bitmap-Daten, um das CRC-Ergebnis der Bitmap-CRC zu erhalten, und Verarbeiten, wenn das Prüfergebnis des Bitmap-CRC-Codes 'inkorrekt' ist, was darauf hinweist, dass die Bitmap-Daten inkorrekt sind, der Dienstdaten nach dem Bitmap-CRC-Code durch Interpretieren aller Dienstdaten als Ethernet, ETH,-Daten und normales Weiterleiten, wenn das Prüfergebnis des Bitmap-CRC-Codes 'korrekt' ist, der Dienstdaten nach dem Bitmap-CRC-Code.

2. Fehlertoleranzverfahren nach Anspruch 1, wobei die Länge des angeordneten Bitmap-CRC-Codes 1 Byte beträgt.

3. Fehlertoleranzverfahren nach Anspruch 2, wobei das Verarbeiten der Dienstdaten nach dem Bitmap-CRC-Code durch Interpretieren aller Dienstdaten als ETH-Daten umfasst:
Interpretieren durch die empfangende Basisbandvorrichtung, wenn das Prüfergebnis des Bitmap-CRC-Codes 'inkorrekt' ist, der ersten 16-Bit-Daten nach dem Bitmap-CRC-Code als einen Medienzugriffssteuerungs, MAC,-Kopf in einer Medienzugriffssteuerungs-Protokolldateneinheit, MAC-PDU, und Analysieren des MAC-Kopfs, um Fragmentinformationen von Nutzlastdaten in der MAC-PDU zu erhalten; Zusammensetzen von Paketen gemäß den Fragmentinformationen der Nutzlastdaten in jeder MAC-PDU, Speichern der zusammengesetzten Pakete und Wiederzusammensetzen der Pakete und Ausgeben und Prüfen der wiederzusammengesetzten Pakete.

4. Fehlertoleranzverfahren nach Anspruch 3, wobei die MAC-PDU umfasst: einen MAC-Kopf und Nutzlastdaten, wobei
die Länge des MAC-Kopfs 16 Bit beträgt, die umfassen: die ersten zwei Bits zum Darstellen der Fragmentinformationen der Nutzlastdaten, die das Fragment eines ETH-Pakets angeben, zu dem die Nutzlastdaten gehören, wobei es sich bei dem Fragment um einen Paketkopf, einen Paketkörper, ein Paket-Ende oder ein vollständiges Paket handelt; elf mittlere Bits zum Darstellen der Länge der Nutzlastdaten und letzte drei Bits zum Darstellen eines anderen Typs von Dienst, der durch einen ETH-Kanal gesendet werden soll; und
die maximale Länge der Nutzlastdaten 2048 Bit beträgt.

5. Fehlertoleranzverfahren nach Anspruch 3 oder 4, wobei das Zusammensetzen von Paketen gemäß den Fragmentinformationen der Nutzlastdaten in jeder MAC-PDU umfasst: Erhalten jedes Fragments in einem ETH-Paket gemäß den Fragmentinformationen, Bilden der Fragmente zu einem vollständigen ETH-Paket und Erhalten der Paketlänge und der Paketdaten des ETH-Pakets.

6. Fehlertoleranzverfahren nach einem der Ansprüche 3 bis 5, wobei das Speichern und Wiederzusammensetzen der zusammengesetzten Pakete umfasst: jeweiliges Speichern der Paketlänge und der Paketdaten des ETH-Pakets in zwei Zuerst-rein-zuerst-raus, FIFO, Speichereinheiten; und Wiederzusammensetzen der Daten in den FIFO-Speichereinheiten gemäß der Paketlänge und den Paketdaten an Ausgängen der FIFO-Speichereinheiten, um das vollständige ETH-Paket zu erhalten.

7. Fehlertoleranzverfahren nach einem der Ansprüche 3 bis 6, wobei das Ausgeben und Prüfen der wiederzusammengesetzten Pakete umfasst: Ausgeben der wiederzusammengesetzten ETH-Pakete und Durchführen der CRC an den wiederzusammengesetzten ETH-Paketen und, wenn das Prüfergebnis 'inkorrekt' ist, Löschen eines Ergebnisses einer Analyse der zusammengesetzten Pakete, der in den FIFO-Speichereinheiten gespeicherten Daten und der Datenausgabe und Erkennen eines MAC-Kopfs eines Paketkopfs in einem ETH-Paket in den nächsten Zeitschlitzdaten zum Zusammensetzen von Paketen.

8. Fehlertoleranzvorrichtung zur Mikrowellenübertragung, umfassend: ein Prüfcodeanordnungsmodul (80) und ein Verarbeitungsmodul (81), wobei
das Prüfcodeanordnungsmodul (80) zum Anordnen eines Bitmap-CRC (zyklische Redundanzprüfung)-Codes nach Bitmap-Daten in Zeitschlitzdaten eines Funkrahmens ausgelegt ist; und
das Verarbeitungsmodul (81) zum Erkennen des Prüfergebnisses des Bitmap-CRC-Codes und Verarbeiten der Dienstdaten nach dem Bitmap-CRC-Code gemäß dem Prüfergebnis ausgelegt ist;
wobei die Länge der Bitmap-Daten 1 Byte beträgt, und der Wert der Bitmap eine Fragmentstruktur von Zeitmultiplex, TDM,-Daten in den Zeitschlitzdaten darstellt; wobei die TDM-Daten in vier Typen von Daten unterteilt sind, und die Bitmap-Daten einen spezifischen Kanal der TDM-Daten angeben, die in aktuellen Zeitschlitzdaten nacheinander gesendet werden; und der angeordnete Bitmap-CRC-Code zum Prüfen der Bitmap-Daten verwendet wird;
wobei das Verarbeitungsmodul (81) ein CRC-Erkennungs-Submodul (90) und ein Datenverarbeitungs-Submodul (91) umfasst, wobei
das CRC-Erkennungs-Submodul (90) so ausgelegt ist, dass es die Bitmap-Daten und den Bitmap-CRC-Code erkennt und eine CC-Prüfung an den Bitmap-Daten durchführt, um das CRC-Ergebnis der Bitmap-CRC zu erhalten; und
das Datenverarbeitungs-Submodul (91) so ausgelegt ist, dass es, wenn das Prüfergebnis des Bitmap-CRC-Codes 'inkorrekt' ist, was darauf hinweist, dass die Bitmap-Daten inkorrekt sind, die Dienstdaten nach dem Bitmap-CRC-Code durch Interpretieren aller Dienstdaten als Ethernet, ETH,-Daten verarbeitet und, wenn das Prüfergebnis des Bitmap-CRC-Codes 'korrekt' ist, die Dienstdaten nach dem Bitmap-CRC-Code normal weiterleitet.

9. Fehlertoleranzvorrichtung nach Anspruch 8, wobei die Länge des angeordneten Bitmap-CRC-Codes 1 Byte beträgt.

10. Fehlertoleranzvorrichtung nach Anspruch 9, wobei das Datenverarbeitungs-Submodul (91) so ausgelegt ist, dass es, wenn das Prüfergebnis des Bitmap-CRC-Codes 'inkorrekt ist, die ersten 16-Bit-Daten nach dem Bitmap-CRC-Code als einen Medienzugriffssteuerungs, MAC,-Kopf in einer Medienzugriffssteuerungs-Protokolldateneinheit, MAC-PDU, interpretiert und den MAC-Kopf analysiert, um Fragmentinformationen von Nutzlastdaten in der MAC-PDU zu erhalten; Pakete gemäß den Fragmentinformationen der Nutzlastdaten in jeder MAC-PDU zusammensetzt, die Pakete speichert und wiederzusammensetzt und die wiederzusammengesetzten Pakete ausgibt und prüft.

11. Fehlertoleranzvorrichtung nach Anspruch 10, wobei die MAC-PDU umfasst: einen MAC-Kopf und Nutzlastdaten, wobei
die Länge des MAC-Kopfs 16 Bit beträgt, die umfassen: die ersten zwei Bits zum Darstellen der Fragmentinformationen der Nutzlastdaten, die das Fragment eines ETH-Pakets angeben, zu dem die Nutzlastdaten gehören, wobei es sich bei dem Fragment um einen Paketkopf, einen Paketkörper, ein Paket-Ende oder ein vollständiges Paket handelt; elf mittlere Bits zum Darstellen der Länge der Nutzlastdaten und letzte drei Bits zum Darstellen eines anderen Typs von Dienst, der durch einen ETH-Kanal gesendet werden soll; und
die maximale Länge der Nutzlastdaten 2048 Bit beträgt.

12. Fehlertoleranzvorrichtung nach Anspruch 10 oder 11, wobei das Datenverarbeitungs-Submodul (91) so ausgelegt ist, dass es beim Zusammensetzen von Paketen gemäß den Fragmentinformationen der Nutzlastdaten in jeder MAC-PDU jedes Fragments in einem ETH-Paket gemäß den Fragmentinformationen erhält, die Fragmente zu einem vollständigen ETH-Paket bildet und die Paketlänge und die Paketdaten des ETH-Pakets erhält.

13. Fehlertoleranzvorrichtung nach einem der Ansprüche 10 bis 12, wobei das Datenverarbeitungs-Submodul (91) so ausgelegt ist, dass es beim Speichern und Wiederzusammensetzen der Pakete die Paketlänge und die Paketdaten des ETH-Pakets jeweils in zwei Zuerst-rein-zuerst-raus, FIFO, Speichereinheiten speichert und die Daten in den FIFO-Speichereinheiten gemäß der Paketlänge und den Paketdaten an Ausgängen der FIFO-Speichereinheiten wiederzusammensetzt, um das vollständige ETH-Paket zu erhalten.

14. Fehlertoleranzvorrichtung nach einem der Ansprüche 10 bis 13, wobei das Datenverarbeitungs-Submodul (91) so ausgelegt ist, dass es beim Ausgeben und Prüfen der wiederzusammengesetzten Pakete die wiederzusammengesetzten ETH-Pakete ausgibt und die CRC an den wiederzusammengesetzten ETH-Paketen durchführt und, wenn das Prüfergebnis 'inkorrekt' ist, ein Ergebnis einer Analyse der zusammengesetzten Pakete, der in den FIFO-Speichereinheiten gespeicherten Daten und der Datenausgabe löscht und einen MAC-Kopf eines Paketkopfs in einem ETH-Paket in den nächsten Zeitschlitzdaten zum Zusammensetzen von Paketen erkennt.

15. Computerlesbares Speichermedium, umfassend Anweisungen, die bei Ausführung durch einen Computer den Computer zum Durchführen des Verfahrens nach einem der Ansprüche 1 bis 7 veranlassen.

## Revendications

1. Procédé de tolérance aux pannes pour une transmission hyperfréquence, comprenant les étapes ci-dessous consistant à :
agencer (301), par le biais d'un dispositif de bande de base de réception, un code de contrôle de redondance cyclique, CRC, matriciel suivant des données matricielles dans des données de tranche de temps d'une trame radio ; et
détecter (302) le résultat de contrôle du code de contrôle CRC matriciel et traiter les données de service suivant le code de contrôle CRC matriciel selon le résultat de contrôle ;
dans lequel la longueur des données matricielles est de « 1 » octet, et la valeur de la matrice de points représente une structure fragmentaire de données de multiplexage par répartition dans le temps, TDM, dans les données de tranche de temps ; dans lequel les données de multiplexage TDM sont divisées en quatre types de données, et les données matricielles indiquent un canal spécifique des données de multiplexage TDM qui sont successivement transmises dans des données de tranche de temps en cours ; et le code de contrôle CRC matriciel agencé est utilisé en vue de contrôler les données matricielles ;
dans lequel l'étape consistant à détecter (302) le résultat de contrôle du code de contrôle CRC matriciel et à traiter les données de service suivant le code de contrôle CRC matriciel selon le résultat de contrôle comprend les étapes consistant à : détecter les données matricielles et le code de contrôle CRC matriciel, mettre en oeuvre un contrôle CRC sur les données matricielles en vue d'obtenir le résultat de contrôle CRC du code de contrôle CRC matriciel, et lorsque le résultat de contrôle du code de contrôle CRC matriciel est « incorrect », ce qui indique que les données matricielles sont incorrectes, traiter les données de service suivant le code de contrôle CRC matriciel en prenant toutes les données de service comme des données Ethernet, ETH, et lorsque le résultat de contrôle du code de contrôle CRC matriciel est « correct », ce qui indique que les données matricielles sont correctes, acheminer les données de service suivant le code de contrôle CRC matriciel de manière conventionnelle.

2. Procédé de tolérance aux pannes selon la revendication 1, dans lequel la longueur du code de contrôle CRC matriciel agencé est de « 1 » octet.

3. Procédé de tolérance aux pannes selon la revendication 2, dans lequel l'étape consistant à traiter les données de service suivant le code de contrôle CRC matriciel en prenant toutes les données de service comme des données ETH comprend les étapes ci-dessous consistant à :
lorsque le résultat de contrôle du code de contrôle CRC matriciel est « incorrect », prendre, par le biais du dispositif de bande de base de réception, les premières données de 16 bits suivant le code de contrôle CRC matriciel en tant qu'un en-tête de contrôle d'accès au support, MAC, dans une unité de données de protocole de contrôle d'accès au support, MAC PDU, et analyser l'en-tête de contrôle MAC en vue d'obtenir des informations de fragments de données de charge utile dans l'unité MAC PDU, assembler des paquets selon les informations de fragments des données de charge utile dans chaque unité MAC PDU, stocker les paquets assemblés et assembler à nouveau les paquets, et fournir en sortir et contrôler les paquets nouvellement assemblés.

4. Procédé de tolérance aux pannes selon la revendication 3, dans lequel l'unité MAC PDU inclut : un en-tête de contrôle MAC et des données de charge utile, dans lequel :
la longueur de l'en-tête de contrôle MAC est de 16 bits, ce qui inclut : les deux premiers bits pour représenter les informations de fragments des données de charge utile qui indiquent le fragment d'un paquet ETH auquel appartiennent les données de charge utile, le fragment correspondant à un en-tête de paquet, un corps de paquet, une queue de paquet ou un paquet complet ; onze bits intermédiaires pour représenter la longueur des données de charge utile ; et les trois derniers bits pour représenter un autre type de service à transmettre par l'intermédiaire d'un canal ETH ; et
la longueur maximale des données de charge utile est de 2 048 bits.

5. Procédé de tolérance aux pannes selon la revendication 3 ou 4, dans lequel l'étape d'assemblage des paquets selon les informations de fragments des données de charge utile dans chaque unité MAC PDU comprend les étapes ci-après consistant à :
obtenir chaque fragment dans un paquet ETH selon les informations de fragments, former les fragments en un paquet ETH complet, et obtenir la longueur de paquet et des données de paquet du paquet ETH.

6. Procédé de tolérance aux pannes selon l'une quelconque des revendications 3 à 5, dans lequel l'étape consistant à stocker et à assembler à nouveau les paquets assemblés comprend les étapes ci-après consistant à : stocker la longueur de paquet et les données de paquet du paquet ETH dans deux unités de stockage de type « premier entré, premier sorti », FIFO, respectivement ; et assembler à nouveau, au niveau de sorties des unités de stockage FIFO, les données des unités de stockage FIFO selon la longueur de paquet et les données de paquet, en vue d'obtenir le paquet ETH complet.

7. Procédé de tolérance aux pannes selon l'une quelconque des revendications 3 à 6, dans lequel l'étape consistant à fournir en sortie et à contrôler les paquets nouvellement assemblés comprend les étapes ci-après consistant à : fournir en sortie les paquets ETH nouvellement assemblés et mettre en oeuvre le contrôle CRC sur les paquets ETH nouvellement assemblés, et lorsque le résultat de contrôle est « incorrect », nettoyer un résultat d'analyse des paquets assemblés, les données stockées dans les unités de stockage FIFO et la sortie de données, et détecter un en-tête de contrôle MAC d'un en-tête de paquet dans un paquet ETH dans les données de tranche de temps successives, en vue d'assembler des paquets.

8. Appareil de tolérance aux pannes pour une transmission hyperfréquence, comprenant : un module d'agencement de code de contrôle (80) et un module de traitement (81), dans lequel
le module d'agencement de code de contrôle (80) est agencé de manière à agencer un code de contrôle de redondance cyclique, CRC, matriciel suivant des données matricielles dans des données de tranche de temps d'une trame radio ; et
le module de traitement (81) est agencé de manière à détecter le résultat de contrôle du code de contrôle CRC matriciel et à traiter les données de service suivant le code de contrôle CRC matriciel selon le résultat de contrôle ;
dans laquelle la longueur des données matricielles est de « 1 » octet, et la valeur de la matrice de points représente une structure fragmentaire de données de multiplexage par répartition dans le temps, TDM, dans les données de tranche de temps ; dans lequel les données de multiplexage TDM sont divisées en quatre types de données, et les données matricielles indiquent un canal spécifique des données de multiplexage TDM qui sont successivement transmises dans des données de tranche de temps en cours ; et le code de contrôle CRC matriciel agencé est utilisé en vue de contrôler les données matricielles ;
dans lequel le module de traitement (81) comprend un sous-module de détection de contrôle CRC (90) et un sous-module de traitement de données (91), dans lequel :
le sous-module de détection de contrôle CRC (90) est agencé de manière à détecter les données matricielles et le code de contrôle CRC matriciel et à mettre en oeuvre un contrôle CRC sur les données matricielles en vue d'obtenir le résultat de contrôle CRC du code de contrôle CRC matriciel ; et
le sous-module de traitement de données (91) est agencé de manière à traiter les données de service suivant le code de contrôle CRC matriciel en prenant toutes les données de service comme des données Ethernet, ETH, lorsque le résultat de contrôle du code de contrôle CRC matriciel est « incorrect », et à acheminer les données de service suivant le code de contrôle CRC matriciel, de manière conventionnelle, lorsque le résultat de contrôle du code de contrôle CRC matriciel est « correct ».

9. Appareil de tolérance aux pannes selon la revendication 8, dans lequel la longueur du code de contrôle CRC matriciel agencé est de « 1 » octet.

10. Appareil de tolérance aux pannes selon la revendication 9, dans lequel le sous-module de traitement de données (91) est agencé de manière à prendre les premières données de 16 bits suivant le code de contrôle CRC matriciel en tant qu'un en-tête de contrôle d'accès au support, MAC, dans une unité de données de protocole de contrôle d'accès au support, MAC PDU, et à analyser l'en-tête de contrôle MAC en vue d'obtenir des informations de fragments de données de charge utile dans l'unité MAC PDU, lorsque le résultat de contrôle du code de contrôle CRC matriciel est « incorrect » ; à assembler des paquets selon les informations de fragments des données de charge utile dans chaque unité MAC PDU, à stocker et à assembler à nouveau les paquets, et à fournir en sortie et contrôler les paquets nouvellement assemblés.

11. Appareil de tolérance aux pannes selon la revendication 10, dans lequel l'unité MAC PDU inclut : un en-tête de contrôle MAC et des données de charge utile, dans lequel :
la longueur de l'en-tête de contrôle MAC est de 16 bits, ce qui inclut : les deux premiers bits pour représenter les informations de fragments des données de charge utile qui indiquent le fragment d'un paquet ETH auquel appartiennent les données de charge utile, le fragment correspondant à un en-tête de paquet, un corps de paquet, une queue de paquet ou un paquet complet ; onze bits intermédiaires pour représenter la longueur des données de charge utile ; et les trois derniers bits pour représenter un autre type de service à transmettre par l'intermédiaire d'une canal ETH ; et
la longueur maximale des données de charge utile est de 2 048 bits.

12. Appareil de tolérance aux pannes selon la revendication 10 ou 11, dans lequel le sous-module de traitement de données (91) est agencé de manière à obtenir, lors de l'assemblage de paquets selon les informations de fragments des données de charge utile dans chaque unité MAC PDU, chaque fragment dans un paquet ETH selon les informations de fragments, à former les fragments en un paquet ETH complet et à obtenir la longueur de paquet et les données de paquet du paquet ETH.

13. Appareil de tolérance aux pannes selon l'une quelconque des revendications 10 à 12, dans lequel le sous-module de traitement de données (91) est agencé de manière à stocker, lors du stockage et du nouvel assemblage des paquets, la longueur de paquet et les données de paquet du paquet ETH, dans deux unités de stockage de type « premier entré, premier sorti », FIFO, respectivement, et à assembler à nouveau, au niveau de sorties des unités de stockage FIFO, les données dans les unités de stockage FIFO, selon la longueur de paquet et les données de paquet, en vue d'obtenir le paquet ETH complet.

14. Appareil de tolérance aux pannes selon l'une quelconque des revendications 10 à 13, dans lequel le sous-module de traitement de données (91) est agencé de manière à fournir en sortie les paquets ETH nouvellement assemblés et à mettre en oeuvre le contrôle CRC sur le paquet ETH nouvellement assemblé, lors de la fourniture en sortie et du contrôle des paquets nouvellement assemblés ; et, lorsque le résultat de contrôle est « incorrect », à nettoyer un résultat d'analyse sur les paquets assemblés, les données stockées dans les unités de stockage FIFO et la sortie de données, et à détecter un en-tête de contrôle MAC d'un en-tête de paquet dans un paquet ETH dans les données de tranche de temps successives en vue d'assembler des paquets.

15. Support de stockage lisible par ordinateur comprenant des instructions qui, lorsqu'elles sont exécutées par un ordinateur, amènent l'ordinateur à mettre en oeuvre le procédé selon l'une quelconque des revendications 1 à 7.
